# EUROPEAN PATENT SPECIFICATION

(11) **EP 4 044 061 B1**
(45) Date of publication and mention of the grant of the patent: **14.05.2025**
(21) Application number: 21759002.5
(22) Date of filing: 02.07.2021
(51) Int. Cl.: B61L 15/00, G06Q 10/0639, G06Q 50/40, G06F 30/00

(54) **SPEED SEGMENTATION METHOD AND APPARATUS, AND ELECTRONIC DEVICE AND STORAGE MEDIUM**
VERFAHREN UND VORRICHTUNG ZUR GESCHWINDIGKEITSSEKTIONIERUNG, ELEKTRONISCHE VORRICHTUNG UND SPEICHERMEDIUM
PROCÉDÉ ET APPAREIL DE SEGMENTATION DE VITESSE, DISPOSITIF ÉLECTRONIQUE ET SUPPORT DE STOCKAGE

(30) Priority: 04.01.2021 CN 202110003485
(43) Date of publication of application: 17.08.2022
(73) Proprietor: CRSC Research & Design Institute Group Co., Ltd., Beijing 100070 (CN)
(72) Inventor: ZHANG, Youbing, Beijing 100070 (CN); WANG, Jianmin, Beijing 100070 (CN); ZHANG, Guozhen, Beijing 100070 (CN); CHEN, Zhiqiang, Beijing 100070 (CN); XIA, Yu, Beijing 100070 (CN); ZHANG, Zhenxing, Beijing 100070 (CN); WANG, Huaijiang, Beijing 100070 (CN)
(74) Representative: Meissner Bolte Partnerschaft mbB
(86) International application number: PCT/CN2021/104140
(87) International publication number: WO 2022/142228

(56) References cited:
- WO-A1-2019/024573
- WO-A1-2020/062844
- CN-A- 107 472 292
- CN-A- 108 549 328
- CN-A- 112 699 563
- US-A1- 2017 003 685
- "Advanced Train Control Systems", vol. 1, 29 June 2010, WIT PRESS, ISBN: 978-1-84564-494-9, article B. FRIMAN: "An algorithm for braking curve calculations in ERTMS train protection systems", pages: 65 - 73, XP055126664, DOI: 10.2495/978-1-84564-494-9/08

## Description

### FIELD OF TECHNOLOGY

Embodiments of the present invention relate to computer technologies, in particular to a method and an apparatus for speed sectioning, an electronic device and a storage medium.

### BACKGROUND

Under normal conditions, braking decelerations of high-speed trains keep changing constantly along with speeds, that is, the trains at different speeds have different braking decelerations. Train braking curves may be acquired by sectioning the speeds and using fixed decelerations in sections, so as to determine travelling speeds of the trains.

Data in various initial speed sections are generally used in the prior art, like WO2019/024573A1. Since there are a great number of initial speed sections, the calculation amount is large, subsequent calculation efficiency and timeliness of safety control are caused to be reduced.

### SUMMARY

Embodiments of the present invention disclose a method and an apparatus for speed sectioning, an electronic device and a storage medium, which improve accuracy and efficiency of speed sectioning.

In a first aspect, the embodiment of the present invention provides the method for sectioning the speed. The method includes:
- determining a coordinate point in an initial deceleration curve according to an end point value of an initial speed section and an initial speed section deceleration;
- determining a curvature at the coordinate point in the initial deceleration curve; and
- determining an end point value of a current speed section from the end point value of the initial speed section according to the curvature at the coordinate point, so as to acquire a current speed section.

In a second aspect, the embodiment of the present invention provides the apparatus for sectioning the speed. The apparatus includes:
- a coordinate point determination module used for determining a coordinate point in an initial deceleration curve according to an end point value of an initial speed section and an initial speed section deceleration;
- a curvature determination module used for determining a curvature at the coordinate point in the initial deceleration curve; and
- an end point value determination module used for determining an end point value of a current speed section from the end point value of the initial speed section according to the curvature at the coordinate point, so as to acquire a current speed section.

In a third aspect, the embodiment of the present invention provides the electronic device. The electronic device includes:
- one or more processors; and
- a storage device used for storing one or more programs,
- the one or more programs, when executed by the one or more processors, enabling the one or more processors to implement the method for speed sectioning above.

In a fourth aspect, the embodiment of the present invention further provides a computer readable storage medium storing a computer program. The method for speed sectioning as described above is implemented when the program is executed by a processor.

The embodiment of the present invention includes: determining the coordinate point in the initial deceleration curve according to the end point value of the initial speed section and the initial speed section deceleration; determining the curvature at the coordinate point in the initial deceleration curve; and determining the end point value of the current speed section from the end point value of the initial speed section according to the curvature at the coordinate point, so as to acquire the current speed section. The problem that since there are a great number of initial speed sections, and a calculation amount is large, subsequent calculation efficiency and timeliness of safety control are caused to be reduced is solved, and accuracy and efficiency of speed sectioning are improved.

### BRIEF DESCRIPTION OF THE DRAWINGS

Fig. 1 is a flowchart of a method for speed sectioning provided by Embodiment 1 of the present invention;
Fig. 2 is a flowchart of a method for speed sectioning provided by Embodiment 2 of the present invention;
Fig. 3 is a structural schematic diagram of an apparatus for speed sectioning provided by Embodiment 3 of the present invention; and
Fig. 4 is a structural schematic diagram of an electronic device provided by Embodiment 4 of the present invention.

### DESCRIPTION OF THE EMBODIMENTS

The present invention will be described in detail below with reference to accompanying drawings and in conjunction with embodiments. It may be understood that particular embodiments described herein are merely used to explain the present invention, rather than limit the present invention. In addition, it should be noted that, for the convenience of description, some rather than all of structures related to the present invention are merely shown in the accompanying drawings.

### Embodiment 1

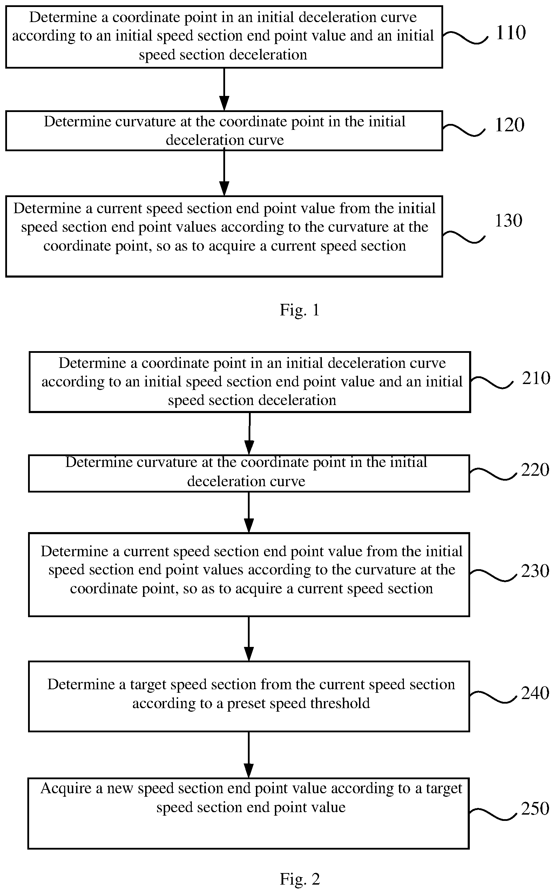

Fig. 1 is a flowchart of a method for speed sectioning provided by Embodiment 1 of the present invention. This embodiment is applicable to determination of a current speed section according to an initial speed section. The method may be implemented by an apparatus for speed sectioning provided by the embodiment of the present invention, and the apparatus may be realized by the means of software and/or hardware. With reference to Fig. 1, the method for sectioning the speed provided by this embodiment includes:
**Step 110.** a coordinate point in an initial deceleration curve is determined according to an end point value of an initial speed section and an initial speed section deceleration.

An initial speed section and the initial speed section deceleration are provided by a train, different initial speed sections and corresponding initial speed section decelerations are determined according to different train types, which are not limited in this embodiment. In one speed section, the deceleration may correspond to a fixed deceleration of the train, that is the initial speed section deceleration, and decelerations corresponding to different speed sections may be same or different, which is not limited in this embodiment.

To be exemplary, an overall speed range of the train is 0-400 km/h, and with increment of the initial speed section being 5 km/h, there are 80 initial speed sections for 0-400 km/h, for example, (0, 5] and (5, 10]. The section (0, 5] corresponds to an initial speed section deceleration a1, and the section (5, 10] corresponds to an initial speed section deceleration a2.

The coordinate point in the initial deceleration curve is determined according to the end point value of the initial speed section and the initial speed section deceleration, for example, the coordinate point is (the end point value of the initial speed section, the initial speed section deceleration), and a next end point value of the initial speed section may be made to correspond to the initial speed section deceleration. To be exemplary, 5 km/h corresponds a1 and 10 km/h corresponds to a2, then the coordinate points in the initial deceleration curve are (5, a1) and (10, a2).

All coordinate points are connected to form the initial deceleration curve.

Step 120. A curvature at the coordinate point in the initial deceleration curve is determined.

The curvature at the coordinate point may be calculated by combining an initial deceleration curve equation with a curvature equation, which is not limited in this embodiment. A curvature corresponding to each coordinate point in the initial deceleration curve is calculated.

In this embodiment, optionally, the determining a curvature at the coordinate point in the initial deceleration curve include:
- acquire a first coordinate value of a previous coordinate point and a second coordinate value of a next coordinate point for a current coordinate point in the initial deceleration curve; and
- determine the curvature at the coordinate point in the initial deceleration curve according to the first coordinate value, the second coordinate value and a coordinate value of the current coordinate point.

The current coordinate point is a coordinate point to be calculated, to be exemplary, the coordinate points are (5, a1), (10, a2) and (15, a3). If the current coordinate point is (10, a2), the first coordinate value of the previous coordinate point is (5, a1), and the second coordinate value of the next coordinate point is (15, a3).

The curvature at the coordinate point in the initial deceleration curve is determined according to the first coordinate value, the second coordinate value and the coordinate value of the current coordinate point, specifically, may be obtained by calculating a curvature radius of the current coordinate point through a three point curvature method. The method above may be used to acquire a curvature of coordinate points except the first coordinate point and the last coordinate point, so as to avoid calculation of an initial deceleration curve equation, reduce a calculation amount and therefore improve efficiency of speed sectioning.

**Step 130.** An end point value of a current speed section is determined from the end point value of the initial speed section according to the curvature at the coordinate point, so as to acquire a current speed section.

The end point value of the current speed section is determined from the end point value of the initial speed section according to the curvature at the coordinate point, an end point value of an initial speed section corresponding to a coordinate point with an abruptly-changed curvature compared with other coordinate points may be taken as the end point value of the current speed section. The curvature is 0.05 or below in general conditions, such that the abruptly-changed curvature indicates that a deceleration trend changes.

To be exemplary, if curvatures at coordinate points corresponding to 20 km/h, 70 km/h, 120 km/h and 300 km/h are relatively large, 0 km/h-400 km/h may be divided into 5 current speed sections, that is (0, 20], (20, 70], (70, 120], (120, 300] and (300, 400].

If there are 80 initial speed sections, the final number of speed sections may be sharply reduced through the manner above, such that calculation efficiency of a train braking curve is improved while accuracy of a follow-up calculation result of the train braking curve is guaranteed, and therefore real-time monitoring of train safe operation by an on-board unit is ensured.

In this embodiment, optionally, determining an end point value of a current speed section from the end point value of the initial speed section according to the curvature at the coordinate point includes:
- determine a curvature threshold according to a curvature of each of the coordinate points; and
- determine a relationship between the curvature at each of the coordinate points and the curvature threshold, and determine the end point value of the current speed section from the end point value of the initial speed section.

The curvature threshold may be determined through several methods, for example, by taking a curvature average as the curvature threshold, or ranking the curvature according to sizes, and selecting the curvature threshold according to the expected number of sections.

The curvature average may be obtained by averaging a sum of curvatures of all coordinate points. A difference between the curvature of each coordinate point and the curvature average is determined, a coordinate point with a difference between its curvature and the curvature average being smaller than the curvature threshold is filtered, and different train types may correspond to different thresholds, which is not limited in this embodiment. To be exemplary, the coordinate point with the difference between its curvature and the curvature average being smaller than 2 is determined as a coordinate point which is not abruptly changed and is filtered, and the current speed section is obtained according to the filtered coordinate point.

Alternatively, the curvature of all the coordinate points are ranked from largest to smallest, and if the speed is expected to be divided into 5 sections, a curvature value ranking 6th is taken as the curvature threshold.

After a relation between the curvature at each coordinate point and the curvature threshold is determined, an end point value of an initial speed section with a curvature greater than the curvature threshold is determined as an end point value of a current speed section, so as to determine the end point value of the current speed section from the end point value of the initial speed section.

The end point value of the current speed section is determined from the end point value of the initial speed section through the curvature threshold, and the speed section is determined according to a change trend of the deceleration, so as to improve accuracy of speed sectioning.

The technical solution provided by this embodiment includes: determining the coordinate point in the initial deceleration curve according to the end point value of the initial speed section and the initial speed section deceleration; determining the curvature at the coordinate point in the initial deceleration curve; and determining the end point value of the current speed section from the end point value of the initial speed section according to the curvature at the coordinate point, so as to acquire the current speed section. The problem that since there are a great number of initial speed sections, and a calculation amount is large, subsequent calculation efficiency and timeliness of safety control are caused to be reduced is solved, and accuracy and efficiency of speed sectioning are improved.

### Embodiment 2

Fig. 2 is a flowchart of a method for speed sectioning provided by Embodiment 2 of the present invention. The technical solution supplementarily describes the process after the determining an end point value of a current speed section from an end point value of an initial speed section , so as to acquire a current speed section. Compared with the above solution, the solution is specifically optimized as follows: after the determining an end point value of a current speed section from the end point value of the initial speed section, so as to acquire a current speed section, the method further includes:
- determine a target speed section from the current speed section according to a preset speed threshold;
- acquire an end point value of a new speed section according to an end point value of the target speed section; and
- update the current speed section according to the end point value of the current speed section and the end point value of the new speed section.

Particularly, a flowchart of the method for sectioning the speed is shown in Fig. 2:
- step 210. a coordinate point in an initial deceleration curve is determined according to an end point value of an initial speed section and an initial speed section deceleration;
- step 220. a curvature is determined at the coordinate point in the initial deceleration curve;
- step 230. an end point value of a current speed section is determined from the end point value of the initial speed section according to the curvature at the coordinate point, so as to acquire a current speed section; and
- step 240. a target speed section is determined from the current speed section according to a preset speed threshold.

The preset speed threshold is used for determining the target speed section with a relatively-high speed from the current speed section. Different present speed thresholds may be arranged for different train types, which is not limited in this embodiment. To be exemplary, the present speed threshold is 120 km/h, then a speed section greater than 120 km/h serves as a target speed section, for example, among (0, 20], (20, 70], (70, 120], (120, 300] and (300, 400], (120, 300] and (300, 400] serve as target speed sections.

Since a braking initial speed is relatively low, a train braking curve calculated is relatively high in precision, and when the braking initial speed is relatively high, the train braking curve calculated is relatively low in precision.

To be exemplary, for speed sections (120, 300] and (300, 400], although a braking deceleration curvature in the speed section is very small, that is, the braking deceleration changes linearly, the speed section has a large span, and a difference between the smallest deceleration and the largest deceleration in the speed section may be great, at this time, that one speed section corresponds to one fixed deceleration may not reflect a deceleration in the overall speed section accurately, such that the target speed section with the relatively-high speed needed to be further processed.

**Step 250.** An end point value of a new speed section is acquired according to an end point value of the target speed section.

The end point value of the new speed section is acquired according to the end point value of the target speed section, specifically, an average of the section end point value may be taken as the end point value of the new speed section or the end point value of the new speed section may be acquired through other manners, which is not limited in this embodiment. To be exemplary, a uniformly-spaced speed section end point 210 is inserted in section (120, 300], and a uniformly-spaced speed section end point 350 is inserted in section (300, 400].

**Step 260,** the current speed section is updated according to the end point value of the current speed section and the end point value of the new speed section.

An original end point value of the current speed section is updated according to the end point value of the new speed section to acquire an updated end point value of the current speed section.

To be exemplary, end point values of the new speed section are 210 and 350, then the updated current speed sections total 7 speed sections, that is, (0, 20], (20, 70], (70, 120], (120, 210], (210, 300], (300, 350] and (350, 400].

In this embodiment, optionally, the current speed section deceleration is determined according to all initial speed section decelerations corresponding to the current speed section.

The current speed section may be the updated speed section according to the end point value of the current speed section and the end point value of the new speed section, or a speed section before updating, which is not limited in this embodiment.

An average or a minimum of all the initial speed section decelerations included in the current speed section may be taken as a fixed deceleration of the current speed section, which further serves as a basis of calculation of train braking curve.

To be exemplary, (0, 20] corresponds to four initial speed sections (0, 5], (5, 10], (10, 15] and (15, 20], all the initial speed sections correspond to initial speed section decelerations a1, a2, a3 and a4 respectively, then a section deceleration corresponding to (0, 20] may be determined by the a1, the a2, the a3 and the a4 jointly. Such that accuracy of acquisition of the current speed section deceleration may be improved.

In this embodiment of the present invention, the speed is sectioned based on the basis of the end point value of the initial speed section and the initial speed section deceleration, the speed is re-sectioned on the basis of the speed threshold, so as to improve the accuracy of the speed sectioning, and further improve precision of the train braking curve calculated when the braking initial speed is relatively high.

### Embodiment 3

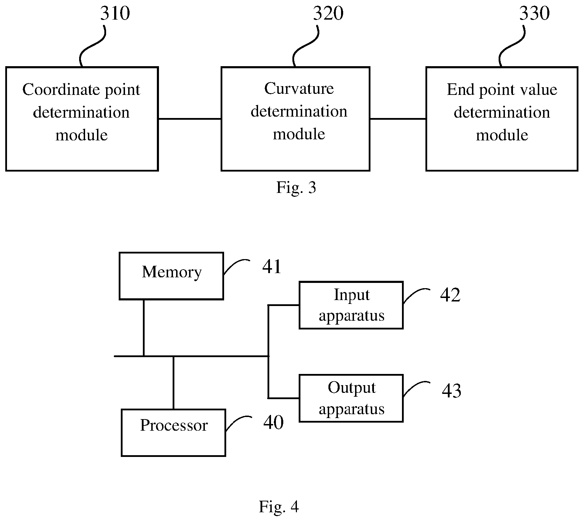

Fig. 3 is a structural schematic diagram of an apparatus for speed sectioning provided by Embodiment 3 of the present invention. The apparatus may be realized through hardware and/or software, may implement the method for sectioning the speed provided by any embodiment of the present invention, and has corresponding functional modules and beneficial effects for implementing the method. As shown in Fig. 3, the apparatus includes:
- a coordinate point determination module 310 used for determining a coordinate point in an initial deceleration curve according to an end point value of an initial speed section and an initial speed section deceleration;
- a curvature determination module 320 used for determining a curvature at the coordinate point in the initial deceleration curve; and
- an end point value determination module 330 used for determining an end point value of a current speed section from the end point value of the initial speed section according to the curvature at the coordinate point, so as to acquire a current speed section.

The embodiment of the present invention includes:
- determining the coordinate point in the initial deceleration curve according to the end point value of the initial speed section and the initial speed section deceleration; determining the curvature at the coordinate point in the initial deceleration curve; and
- determining the end point value of the current speed section from the end point value of the initial speed section according to the curvature at the coordinate point, so as to acquire the current speed section. The problem that data in various initial speed sections are generally acquired, since there are a great number of initial speed sections, the calculation amount is large, subsequent calculation efficiency and timeliness of safety control are caused to be reduced is solved, so as to improve accuracy and efficiency of speed sectioning.

Based on the technical solutions above, optionally, the curvature determination module includes:
- a coordinate value acquisition unit used for acquiring a first coordinate value of a previous coordinate point and a second coordinate value of a next coordinate point for a current coordinate point in the initial deceleration curve; and
- a curvature determination unit used for determining the curvature at the coordinate point in the initial deceleration curve according to the first coordinate value, the second coordinate value and a coordinate value of the current coordinate point.

Based on the technical solutions above, optionally, the end point value determination module includes:
- a curvature threshold determination unit used for determining a curvature threshold according to a curvature of each of the coordinate points; and
- an end point value determination unit used for determining a relationship between a curvature at each of the coordinate points and the curvature threshold and determining the end point value of the current speed section from the end point value of the initial speed section.

Based on the technical solutions above, optionally, the apparatus may further include:
- a target speed section determination module used for determining, after the end point value determination module, a target speed section from the current speed section according to a preset speed threshold;
- a new speed section end point value acquisition module used for acquiring an end point value of a new speed section according to an end point value of the target speed section; and
- a current speed section updating module used for updating the current speed section according to the end point value of the current speed section and the end point value of the new speed section.

Based on the technical solutions above, optionally, the apparatus further includes:
- a current speed section deceleration determination module used for determining a current speed section deceleration according to all initial speed section decelerations corresponding to the current speed section.

### Embodiment 4

Fig. 4 is a structural schematic diagram of an electronic device provided by Embodiment 4 of the present invention. As shown in Fig. 4, the electronic device includes a processor 40, a memory 41, an input apparatus 42 and an output apparatus 43. One or more processors 40 of the electronic device may be arranged, and one processor 40 is taken as an example in Fig. 4. The processor 40, the memory 41, the input apparatus 42 and the output apparatus 43 of the electronic device may be connected through a bus or other manners, with the bus as an example in Fig. 4.

The memory 41, as a computer readable storage medium, may be used in a storage software program, and a computer executable program and module, such as a program instruction/module corresponding to a method for speed sectioning in an embodiment of the present invention. The processor 40 operates a software program, instruction and module stored in the memory 41, so as to execute various functional applications and data processing and implement the method for sectioning the speed above.

The memory 41 may mainly include a program storage area and a data storage area, wherein the program storage area may be used to store an operating system, application programs required for at least one function. The data storage area may store data, etc. created according to a terminal. In addition, the memory 41 may include a high-speed random access memory, and may further include a non-volatile memory such as at least one disk storage device, a flash storage device or another volatile solid-state storage device. In some embodiments, the memory 41 may further include a memory which is remotely arranged opposite the processor 40, and the remote memory may be connected to the electronic device through the network. Examples of the network include but are not limited to the Internet, the Intranet, local area network, the mobile communication network and the combinations thereof.

### Embodiment 5

Embodiment 5 of the present invention further provides a storage medium including a computer executable instruction. The computer executable instruction is used for implementing a method for speed sectioning when executed by a computer processor. The method includes:
- determine a coordinate point in an initial deceleration curve according to an end point value of an initial speed section and an initial speed section deceleration;
- determine a curvature at the coordinate point in the initial deceleration curve; and
- determine an end point value of a current speed section from the end point value of the initial speed section according to the curvature at the coordinate point, so as to acquire a current speed section.

It is certain that the embodiment of the present invention provides the storage medium including the computer executable instruction. The computer executable instruction is not limited to operation of the method above, and may also implement relevant operation in the method for sectioning the speed provided by any embodiment of the present invention.

From the above description of the embodiment, it may be clearly understood by those skilled in the art that the present invention may be implemented by means of software and necessary general hardware, and may be certainly realized by the hardware, among which the former is a preferred embodiment in many cases. Based on such understanding, a technical solution of the present invention may be embodied in the form of software products in essence or in part that contributes to the prior art, the computer software products may be stored in the computer readable storage medium, such as a floppy disk, a Read-Only Memory (ROM), a Random Access Memory (RAM), a FLASH memory, a hard disk or optical disk, etc. of a computer, and several instructions are included to make computer equipment (which may be a personal computer, a server, network equipment, etc.) execute the method of each embodiment of the present invention.

It is worth noting that all the units and modules included in the embodiment of the apparatus for sectioning the speed above are merely divided according to a functional logic, but are not limited to the above division, as long as the corresponding functions may be realized. In addition, particular names of each functional unit are merely for the convenience of mutual distinguishing, and are not used to limit the protection scope of the present invention.

It should be noted that the above-mentioned is merely a preferred embodiment of the present invention and an applied technical principle. Those skilled in the art may understand that the present invention is not limited to a specific embodiment described herein, and may make various obvious changes, readjustments and substitutions without departing from the protection scope of the present invention. Therefore, although the present invention has been described relatively in detail through the above embodiment, the present invention is not merely limited to the above embodiment, but may also include more other equivalent embodiments without departing from the concept of the present invention, and the scope of the present invention is determined by the scope of the appended claims.

## Claims

1. A computer-implemented method for speed sectioning of a train based on an overall speed section having an initial deceleration curve, the overall speed section comprising a plurality of initial speed sections, each initial speed section having a speed range ((0,5], (5,10], ... , (395, 400]) with an end point value and a deceleration value (a1, a2), wherein the method reduces the number of speed sections and comprises the steps:
a) determining for each initial speed section a coordinate point (v, a), the coordinate point having a speed value and a coordinate point deceleration value, wherein the respective coordinate point is determined according to the end point value of the respective initial speed section and an the deceleration value of the respective initial speed section;
b) determining a curvature at each coordinate point; and
c) determining an end point value of a current speed section from one of the end point values of the initial speed sections using the curvature at the coordinate points, so as to acquire the current speed section, wherein at least one end point value of the current speed section is determined such that the current speed section has a speed range ((0,20]) comprising several speed ranges of the initial speed ranges;
wherein the reduced number of speed sections is used to efficiently calculate a train braking curve while guaranteeing accuracy of a follow-up calculation result and therefore enabling an on-board unit of a train to monitor a safe operation of the train in real-time.

2. The method according to claim 1, **characterized in that** the determining a curvature at the coordinate point in the initial deceleration curve comprises:
acquiring a first coordinate value of a previous coordinate point and a second coordinate value of a next coordinate point for a current coordinate point in the initial deceleration curve; and
determining the curvature at the coordinate point in the initial deceleration curve according to the first coordinate value, the second coordinate value and a coordinate value of the current coordinate point.

3. The method according to claim 1, **characterized in that** the determining an end point value of the current speed section from the end point value of the initial speed section according to the curvature at the coordinate point, so as to acquire the current speed section comprises:
determining a curvature threshold according to a curvature of each of the coordinate points; and
determining a relationship between the curvature at each of the coordinate points and the curvature threshold, and determining the end point value of the current speed section from the end point value of the initial speed section.

4. The method according to claim 1, **characterized in that** after determining end point values of current speed sections from end point values of the initial speed sections, so as to acquire the current speed sections, the method further comprises:
determining a target speed section from the current speed sections according to a preset speed threshold;
acquiring an end point value of a new speed section according to an end point value of the target speed section; and
updating the current speed sections according to the end point values of the current speed sections and the end point value of the new speed section.

5. The method according to any one of claims 1-4, **characterized in that** the method further comprises:
determining a deceleration of the current speed section according to decelerations of all initial speed sections corresponding to the current speed section.

6. An electronic device, **characterized in that** the electronic device comprises:
one or more processors; and
a storage device used for storing one or more programs,
the one or more programs, when executed by the one or more processors, enabling the one or more processors to implement the method for sectioning a speed according to any one of claims 1-5.

7. A computer readable storage medium storing a computer program, **characterized in that** the program, when executed by a processor, implements the method for sectioning the speed according to any one of claims 1-5.

## Patentansprüche

1. Computerimplementiertes Verfahren zur Geschwindigkeitssektionierung eines Zuges auf Grundlage einer Gesamtgeschwindigkeitssektion, die eine Anfangsverzögerungskurve aufweist, wobei die Gesamtgeschwindigkeitssektion eine Vielzahl von Anfangsgeschwindigkeitssektionen umfasst, wobei jede Anfangsgeschwindigkeitssektion einen Geschwindigkeitsbereich ((0,5], (5,10], ..., (395, 400]) mit einem Endpunktwert und einem Verzögerungswert (a1, a2) aufweist, wobei das Verfahren die Anzahl von Geschwindigkeitssektionen verringert und die folgenden Schritte umfasst:
a) Bestimmen eines Koordinatenpunkts (v, a) für jede Anfangsgeschwindigkeitssektion, wobei der Koordinatenpunkt einen Geschwindigkeitswert und einen Koordinatenpunktverzögerungswert aufweist, wobei der jeweilige Koordinatenpunkt gemäß dem Endpunktwert der jeweiligen Anfangsgeschwindigkeitssektion und dem Verzögerungswert der jeweiligen Anfangsgeschwindigkeitssektion bestimmt wird;
b) Bestimmen einer Krümmung an jedem Koordinatenpunkt; und
c) Bestimmen eines Endpunktwerts einer aktuellen Geschwindigkeitssektion aus einem der Endpunktwerte der Anfangsgeschwindigkeitssektionen unter Verwendung der Krümmung an den Koordinatenpunkten, um die aktuelle Geschwindigkeitssektion zu erfassen, wobei mindestens ein Endpunktwert der aktuellen Geschwindigkeitssektion derart bestimmt wird, dass die aktuelle Geschwindigkeitssektion einen Geschwindigkeitsbereich ((0,20]) aufweist, der mehrere Geschwindigkeitsbereiche der Anfangsgeschwindigkeitsbereiche umfasst;
wobei die verringerte Anzahl von Geschwindigkeitssektionen verwendet wird, um eine Zugbremskurve effizient zu berechnen, während Genauigkeit eines Nachberechnungsergebnisses garantiert wird und es daher einer bordeigenen Einheit eines Zuges ermöglicht wird, einen sicheren Betrieb des Zuges in Echtzeit zu überwachen.

2. Verfahren nach Anspruch 1, **dadurch gekennzeichnet, dass** das Bestimmen einer Krümmung an dem Koordinatenpunkt in der Anfangsverzögerungskurve Folgendes umfasst:
Erfassen eines ersten Koordinatenwerts eines vorherigen Koordinatenpunkts und eines zweiten Koordinatenwerts eines nächsten Koordinatenpunkts für einen aktuellen Koordinatenpunkt in der Anfangsverzögerungskurve; und
Bestimmen der Krümmung an dem Koordinatenpunkt in der Anfangsverzögerungskurve gemäß dem ersten Koordinatenwert, dem zweiten Koordinatenwert und einem Koordinatenwert des aktuellen Koordinatenpunkts.

3. Verfahren nach Anspruch 1, **dadurch gekennzeichnet, dass** das Bestimmen eines Endpunktwerts der aktuellen Geschwindigkeitssektion aus dem Endpunktwert der Anfangsgeschwindigkeitssektion gemäß der Krümmung an dem Koordinatenpunkt, um die aktuelle Geschwindigkeitssektion zu erfassen, Folgendes umfasst:
Bestimmen eines Krümmungsschwellenwerts gemäß einer Krümmung von jedem der Koordinatenpunkte; und
Bestimmen einer Beziehung zwischen der Krümmung an jedem der Koordinatenpunkte und dem Krümmungsschwellenwert und Bestimmen des Endpunktwerts der aktuellen Geschwindigkeitssektion aus dem Endpunktwert der Anfangsgeschwindigkeitssektion.

4. Verfahren nach Anspruch 1, **dadurch gekennzeichnet, dass** das Verfahren nach dem Bestimmen von Endpunktwerten von aktuellen Geschwindigkeitssektionen aus den Endpunktwerten der Anfangsgeschwindigkeitssektionen, um die aktuellen Geschwindigkeitssektionen zu erfassen, ferner Folgendes umfasst:
Bestimmen einer Zielgeschwindigkeitssektion aus den aktuellen Geschwindigkeitssektionen gemäß einem voreingestellten Geschwindigkeitsschwellenwert;
Erfassen eines Endpunktwerts einer neuen Geschwindigkeitssektion gemäß einem Endpunktwert der Zielgeschwindigkeitssektion; und
Aktualisieren der aktuellen Geschwindigkeitssektionen gemäß den Endpunktwerten der aktuellen Geschwindigkeitssektionen und dem Endpunktwert der neuen Geschwindigkeitssektion.

5. Verfahren nach einem der Ansprüche 1-4, **dadurch gekennzeichnet, dass** das Verfahren ferner Folgendes umfasst:
Bestimmen einer Verzögerung der aktuellen Geschwindigkeitssektion gemäß Verzögerungen aller Anfangsgeschwindigkeitssektionen, die der aktuellen Geschwindigkeitssektion entsprechen.

6. Elektronische Vorrichtung, **dadurch gekennzeichnet, dass** die elektronische Vorrichtung Folgendes umfasst:
einen oder mehrere Prozessoren; und
eine Speichervorrichtung, die zum Speichern eines oder mehrerer Programme verwendet wird,
wobei das eine oder die mehreren Programme bei Ausführung durch den einen oder die mehreren Prozessoren es dem einen oder den mehreren Prozessoren ermöglichen, das Verfahren zum Sektionieren einer Geschwindigkeit nach einem der Ansprüche 1-5 umzusetzen.

7. Computerlesbares Speichermedium, auf dem ein Computerprogramm gespeichert ist, **dadurch gekennzeichnet, dass** das Programm bei Ausführung durch einen Prozessor das Verfahren zum Sektionieren der Geschwindigkeit nach einem der Ansprüche 1-5 umsetzt.

## Revendications

1. Procédé implémenté par ordinateur pour le sectionnement de vitesse d'un train sur la base d'une section de vitesse globale ayant une courbe de décélération initiale, la section de vitesse globale comprenant une pluralité de sections de vitesse initiales, chaque section de vitesse initiale ayant une plage de vitesse ((0,5], (5,10], .... , (395, 400]) avec une valeur de point final et une valeur de décélération (al, a2), dans lequel le procédé réduit le nombre de sections de vitesse et comprend les étapes :
a) de détermination pour chaque section de vitesse initiale d'un point de coordonnées (v, a), le point de coordonnées ayant une valeur de vitesse et une valeur de décélération de point de coordonnées, dans lequel le point de coordonnées respectif est déterminé selon la valeur de point final de la section de vitesse initiale respective et une la valeur de décélération de la section de vitesse initiale respective ;
b) de détermination d'une courbure à chaque point de coordonnées ; et
c) de détermination d'une valeur de point final d'une section de vitesse courante à partir de l'une des valeurs de point final des sections de vitesse initiales en utilisant la courbure aux points de coordonnées, de façon à acquérir la section de vitesse courante, dans lequel au moins une valeur de point final de la section de vitesse courante est déterminée de sorte que la section de vitesse courante ait une plage de vitesse ((0,20]) comprenant plusieurs plages de vitesse des plages de vitesse initiales ;
dans lequel le nombre réduit de sections de vitesse est utilisé pour calculer efficacement une courbe de freinage de train tout en garantissant la précision d'un résultat de calcul de suivi et en permettant donc à une unité embarquée d'un train de surveiller un fonctionnement sûr du train en temps réel.

2. Procédé selon la revendication 1, **caractérisé en ce que** la détermination d'une courbure au point de coordonnées dans la courbe de décélération initiale comprend :
l'acquisition d'une première valeur de coordonnées d'un point de coordonnées précédent et d'une deuxième valeur de coordonnées d'un point de coordonnées suivant pour un point de coordonnées courant dans la courbe de décélération initiale ; et
la détermination de la courbure au point de coordonnées dans la courbe de décélération initiale selon la première valeur de coordonnées, la deuxième valeur de coordonnées et une valeur de coordonnées du point de coordonnées courant.

3. Procédé selon la revendication 1, **caractérisé en ce que** la détermination d'une valeur de point final de la section de vitesse courante à partir de la valeur de point final de la section de vitesse initiale selon la courbure au point de coordonnées, de façon à acquérir la section de vitesse courante comprend :
la détermination d'un seuil de courbure selon une courbure de chacun des points de coordonnées ; et
la détermination d'une relation entre la courbure à chacun des points de coordonnées et le seuil de courbure, et la détermination de la valeur de point final de la section de vitesse courante à partir de la valeur de point final de la section de vitesse initiale.

4. Procédé selon la revendication 1, **caractérisé en ce que**, après détermination des valeurs de point final des sections de vitesse courantes à partir des valeurs de point final des sections de vitesse initiales, de façon à acquérir les sections de vitesse courantes, le procédé comprend en outre :
la détermination d'une section de vitesse cible à partir des sections de vitesse courantes selon un seuil de vitesse prédéfini ;
l'acquisition d'une valeur de point final d'une nouvelle section de vitesse selon une valeur de point final de la section de vitesse cible ; et
la mise à jour des sections de vitesse courantes selon les valeurs de point final des sections de vitesse courantes et la valeur de point final de la nouvelle section de vitesse.

5. Procédé selon l'une quelconque des revendications 1 à 4, **caractérisé en ce que** le procédé comprend en outre :
la détermination d'une décélération de la section de vitesse courante selon les décélérations de toutes les sections de vitesse initiales correspondant à la section de vitesse courante.

6. Dispositif électronique, **caractérisé en ce que** le dispositif électronique comprend :
un ou plusieurs processeurs ; et
un dispositif de stockage utilisé pour stocker un ou plusieurs programmes,
les un ou plusieurs programmes, lorsqu'ils sont exécutés par les un ou plusieurs processeurs, permettant aux un ou plusieurs processeurs d'implémenter le procédé de sectionnement d'une vitesse selon l'une quelconque des revendications 1 à 5.

7. Support de stockage lisible par ordinateur stockant un programme d'ordinateur, **caractérisé en ce que** le programme, lorsqu'il est exécuté par un processeur, implémente le procédé de sectionnement de la vitesse selon l'une quelconque des revendications 1 à 5.
